# EUROPEAN PATENT SPECIFICATION

(11) **EP 3 664 155 B1**
(45) Date of publication and mention of the grant of the patent: **18.11.2026**
(21) Application number: 18873145.9
(22) Date of filing: 14.09.2018
(51) Int. Cl.: H10F 77/20, H10F 19/40, H10F 19/90, H10F 10/166

(54) **DOUBLE-SIDED ELECTRODE TYPE SOLAR CELL AND SOLAR CELL MODULE**
DOPPELSEITIGE ELEKTRODENARTIGE SOLARZELLE UND SOLARZELLENMODUL
CELLULE SOLAIRE DE TYPE À ÉLECTRODE À DOUBLE FACE ET MODULE DE CELLULE SOLAIRE

(30) Priority: 30.10.2017 JP 2017209637
(43) Date of publication of application: 10.06.2020
(73) Proprietor: Kaneka Corporation, Osaka-shi, Osaka 530-8288 (JP)
(72) Inventor: TAKAHASHI Yuji, Settsu-shi Osaka 566-0072 (JP); YOSHIKAWA Kunta, Settsu-shi Osaka 566-0072 (JP); OMOTO Shinya, Settsu-shi Osaka 566-0072 (JP)
(74) Representative: Hoffmann Eitle
(86) International application number: PCT/JP2018/034222
(87) International publication number: WO 2019/087590

(56) References cited:
- WO-A1-2014/132312
- WO-A1-2015/152020
- JP-A- 2004 228 281
- JP-A- 2005 229 089
- JP-A- 2005 229 089
- JP-A- 2014 199 875
- JP-A- 2015 198 142
- JP-A- 2015 198 142
- US-A1- 2015 364 616
- US-A1- 2017 256 661

## Description

The present invention relates to a double-sided electrode type solar cell module.

### BACKGROUND ART

Currently, in a case where double-sided electrode type solar cells are modularized, there is a method in which parts of the solar cell are overlapped with each other without using a conductive connection line, and thus, the solar cell are directly, electrically, and physically connected (for example, Patent Document 1).

Such a connection method is referred to as a singling method. According to such a method, it is possible to mount many more solar cells in a limited solar cell mounting area of a solar cell module, and a light receiving area for photoelectric conversion increases, and thus, it is considered that the output of the solar cell module is improved.

Patent Document 2 discloses a. solar cell wherein a light diffusion portion is provided between an invalid area of the cell surface and a sealing layer. This concerns the presence of an invalid area at the periphery of the cell surface that receives incident light but does not convert this light into electricity. To utilize such incident light, the light diffusion portion is used to scatter the light from the invalid area toward an area that does contribute to the generation of electricity

Patent Document 1: Japanese Unexamined Patent Application, Publication No. H11-186577

Patent Document 2: US patent application No. US2015364616.

### DISCLOSURE OF THE INVENTION

### Problems to be Solved by the Invention

However, in the solar cell module in which a light receiving area is simply increased, it is actually difficult to improve output. This is because the output is improved by not only the light receiving area but also various other factors. A dark current that is generated between pn junctions of the solar cell is considered as one of the factors. This is because in a case where the dark current is generated, an operating point voltage of the solar cell decreases, and thus, the output decreases. Then, in the case of a singling method, a part of one solar cell is light-shielded by a part of another solar cell, and thus, the dark current is easily generated.

In order to suppress such a dark current, it is sufficient to narrow an area in which the parts of the solar cells overlap each other, but in such a case, physical connection area is narrowed, and thus, a connection strength between the solar cells is insufficient. In addition, in order to electrically and physically connect the solar cells, for example, a conductive adhesive agent is interposed between the parts of the solar cells that overlap each other, but such a conductive adhesive agent spreads at the time of thermal compression bonding, and extends up to a light receiving surface of the solar cell, and thus, may cause a shadow loss.

The present invention has been made in order to solve the problems described above. An object thereof is to provide a solar cell module that exhibits high output while ensuring a connection strength between solar cells, and a solar cell suitable for the solar cell module.

### Means for Solving the Problems

The present invention provides a solar cell module as defined in the claims.

### Effects of the Invention

The solar cell module exhibits high output while ensuring a connection strength between the solar cells.

### BRIEF DESCRIPTION OF THE DRAWINGS

Fig. 1 is a partially enlarged view of a sectional view of a solar cell module illustrated in Fig. 6 described below.
Fig. 2 is a partially enlarged view illustrating another example of Fig. 1.
Fig. 3 is a perspective view of a solar cell.
Fig. 4 is a plan view of the solar cell.
Fig. 5 is a plan view of a solar cell module.
Fig. 6 is a sectional view of the solar cell module.
Fig. 7 is a perspective view of the solar cell.
Fig. 8 is a plan view of the solar cell.
Fig. 9 is a perspective view of the solar cell.
Fig. 10 is a plan view of the solar cell.

### PREFERRED MODE FOR CARRYING OUT THE INVENTION

Note that, there is a case where hatching, member reference numerals, and the like are omitted for the sake of convenience, but in such a case, other drawings will be referred to. In addition, the dimension of various members in the drawings is adjusted to be easily viewable, for the sake of convenience.

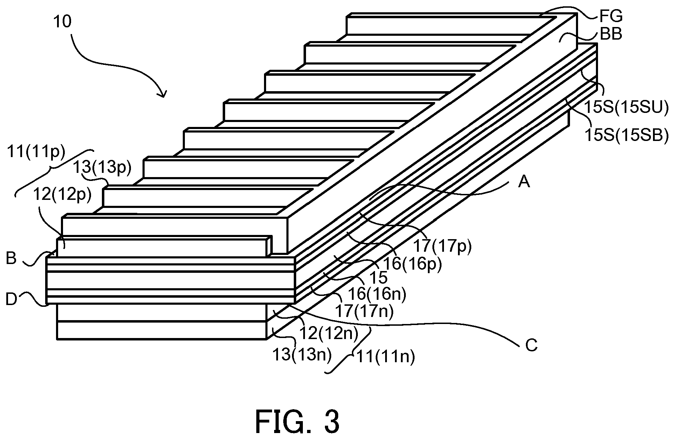

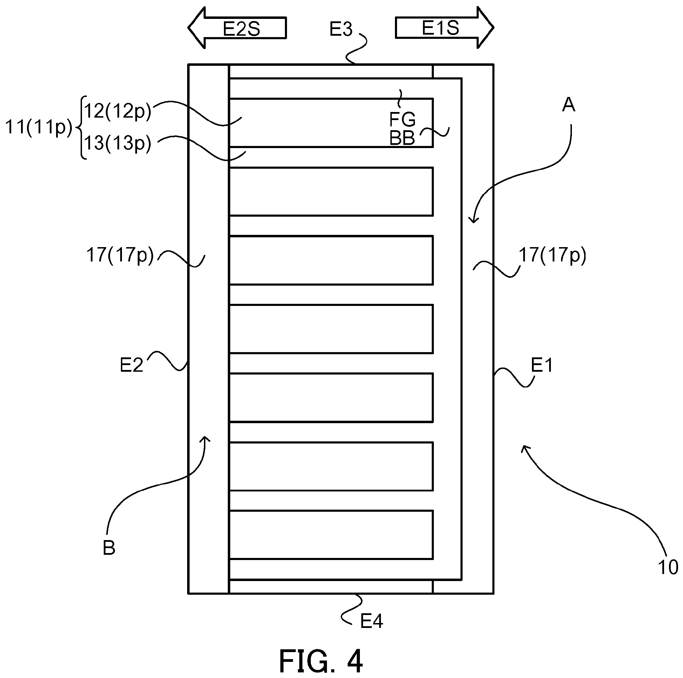

A perspective view of Fig. 3 illustrates a solar cell 10 using a silicon-made semiconductor substrate 15, and Fig. 4 is a plan view of Fig. 3. As illustrated in Fig. 3, the semiconductor substrate 15 includes two major surfaces 15S (15SU and 15SB). Therefore, in the present specification, in two major surfaces 15S, the major surface 15S on one surface side is defined as a surface 15SU, and the major surface 15S on the other surface side is defined as a back surface 15SB. In addition, in the surface 15SU and the back surface 15SB, one surface is described as a light reception side [a light receiving surface side] that actively receives light compared to the other surface, and the other surface that does not actively receive light is described as a non-light receiving backside [a back surface side].

A so-called hetero junction crystal silicon solar cell will be described as the solar cell 10. The solar cell 10 includes the semiconductor substrate 15, intrinsic semiconductor layers 16, conductivity type semiconductor layers 17 (a p-type semiconductor layer 17p and an n-type semiconductor layer 17n), and electrode layers 11 (a transparent oxide electrode layers 12 and a metal electrode layers 13). Note that, in the following description, for the sake of convenience, in members individually associated with the p-type semiconductor layer 17p or the n-type semiconductor layer 17n, "p" or "n" may be applied to the ends of the member reference numerals.

The semiconductor substrate 15 may be a substrate formed of monocrystalline silicon (a silicon wafer), or may be a substrate formed of polycrystalline silicon. Hereinafter, a monocrystalline silicon substrate will be described as an example.

In addition, the conductive type of the semiconductor substrate 15 may be either an n-type monocrystalline silicon substrate containing impurities (for example, a phosphorus atom) that introduce an electron into a silicon atom, or may be a p-type monocrystalline silicon substrate containing impurities (for example, a boron atom) that introduce a hole into a silicon atom. Hereinafter, the n-type semiconductor substrate 15 supposedly having a long carrier lifetime will be described as an example.

In addition, it is preferable that in the semiconductor substrate 15, at least the light receiving surface 15SU of two major surfaces 15SU and 15SB has a texture structure having mountains (protrusions) and valleys (depressions) formed, from the viewpoint of trapping received light. Note that, the texture structure (an uneven surface), for example, is formed by anisotropic etching to which a difference between an etching rate of a (100) surface of the semiconductor substrate 15 and an etching rate of a (111) surface is applied.

In addition, it is preferable that the thickness of the semiconductor substrate 15 is less than or equal to 200 µm from the viewpoint of suppressing the amount of silicon that is used. Note that, a measurement direction in the case of measuring the thickness is a direction vertical to an average surface of the semiconductor substrate 15 (the average surface indicates a surface as the entire substrate that does not depend on the texture structure). Therefore, hereinafter, such a vertical direction, that is, a direction for measuring the thickness, will be described as a thickness direction for measuring film thicknesses of various layers.

On the other hand, in a case where the thickness of the semiconductor substrate 15 is excessively small, a mechanical strength decreases, or external light (sunlight or the like) is not sufficiently absorbed, and a short-circuit current density may decrease. For this reason, the thickness of the semiconductor substrate 15 is preferably greater than or equal to 50 µm, and is more preferably greater than or equal to 70 µm. Note that, in a case where the texture structure is formed on the major surface 15S of the semiconductor substrate 15, the thickness of the semiconductor substrate 15 is represented by a maximum distance between straight lines connecting vertexes of protrusions in a depression-protrusion structure on each of the light reception side and the backside.

Note that, in a case where the silicon wafer is 5-inch squares and 6-inch squares, the silicon wafer may be used as the semiconductor substrate 15 by being cut. In such a case, the solar cell 10 having a size smaller than that of the silicon wafer is obtained, and thus, a thin and flexible semiconductor substrate 15 is less likely to be damaged.

In addition, as illustrated in Fig. 4, it is preferable that a planar shape of the semiconductor substrate 15 is an approximately rectangular shape including four sides E1 to E4, and it is more preferable that the planar shape is an approximately oblong shape including long sides E1 and E2 and short sides E3 and E4. In the present specification, the "approximately rectangular shape" includes not only a complete rectangular shape (an oblong shape including a square shape) but also a shape in which at least one corner is missing, such as a shape in which at least one corner is rounded. Similarly, the "approximately oblong shape" includes not only a complete oblong shape but also a shape in which at least one corner is missing, such as a shape in which at least one corner is rounded.

The intrinsic semiconductor layers 16 (16p and 16n) individually directly cover both of the approximately rectangular major surfaces 15S (15SU and 15SB) of the semiconductor substrate 15, and thus perform surface passivation while suppressing impurity diffusion to the semiconductor substrate 15. Note that, the "intrinsic (i type)" semiconductor layer is not limited to a completely intrinsic layer that does not contain conductive impurities, and also includes a "weak n-type" or "weak p-type" substantially intrinsic layer containing a slight amount of n-type impurities or p-type impurities in a range in which a silicon-based layer is capable of functioning as an intrinsic layer.

In addition, in Fig. 3, the shape and the area of the intrinsic semiconductor layer 16p are approximately identical to those of the major surface 15SU of the semiconductor substrate 15, and the shape and the area of the intrinsic semiconductor layer 16n are approximately identical to those of the major surface 15SB of the semiconductor substrate 15. However, the present invention is not limited thereto.

The material of the intrinsic semiconductor layer 16 is not particularly limited, but an amorphous silicon-based thin film is preferable, a hydrogenated amorphous silicon-based thin film layer containing silicon and hydrogen is more preferable, as the material. In addition, a forming method of the intrinsic semiconductor layer 16 is not particularly limited, but a plasma chemical vapor deposition (CVD) method is preferable as the forming method.

This is because in a case where such a thin film is subjected to CVD film formation on the semiconductor substrate 15 formed of monocrystalline silicon, the passivation of the surface of the substrate is effectively performed while suppressing the diffusion of the impurities to the monocrystalline silicon. In addition, in the plasma CVD method, a hydrogen concentration in the film of the intrinsic semiconductor layer 16 is changed in a film thickness direction, and an effective energy gap profile is also formed in collecting carriers.

Note that, for example, it is preferable that a substrate temperature is higher than or equal to 100°C and lower than or equal to 300°C, a pressure is greater than or equal to 20 Pa and less than or equal to 2600 Pa, and a high-frequency power density is greater than or equal to 0.003 W/cm² and less than or equal to 0.5 W/cm², as a condition for forming the thin film by the plasma CVD method.

In addition, in the case of the hydrogenated amorphous silicon-based thin film, silicon-containing gas such as SiH₄ and Si₂H₆, or a mixture of such gas and H₂ is preferable as raw material gas that is used for forming the thin film.

Examples of the conductivity type semiconductor layers 17 include the p-type semiconductor layer 17p and the n-type semiconductor layer 17n. In the solar cell 10 illustrated in Fig. 3, the p-type semiconductor layer 17p is formed on the approximately rectangular intrinsic semiconductor layer 16p that is formed on the major surface (the light receiving surface) 15SU of the semiconductor substrate 15 on the light reception side, and the n-type semiconductor layer 17n is formed on the approximately rectangular intrinsic semiconductor layer 16n that is formed on the major surface (the back surface) 15SB of the semiconductor substrate 15 on the backside.

As described above, in a case where the conductivity type semiconductor layers 17 are individually formed on one surface side and the other surface side of the major surfaces 15SU and 15SB of the semiconductor substrate 15, the electrode layers 11 are also individually formed on one surface side and the other surface side of the semiconductor substrate 15. For this reason, such a solar cell 10 is referred to as a double-sided electrode type solar cell 10.

In addition, in Fig. 3, the shape and the area of the p-type semiconductor layer 17p are approximately identical to those of the intrinsic semiconductor layer 16p, and the major surface 15SU of the semiconductor substrate 15, and the shape and the area of the n-type semiconductor layer 17n are approximately identical to those of the intrinsic semiconductor layer 16n, and the major surface 15SB of the semiconductor substrate 15. However, the present invention is not limited thereto. In addition, a manufacturing method of the conductivity type semiconductor layer 13 is not particularly limited, but as with the intrinsic semiconductor layer 16, the plasma CVD method is preferable as the manufacturing method.

The p-type semiconductor layer 17p is formed of a silicon layer to which a p-type dopant (boron or the like) is added. Examples of the p-type semiconductor layer include a p-type hydrogenated amorphous silicon layer, a p-type amorphous silicon carbide layer, or a p-type amorphous silicon oxide layer. Note that, it is preferable that the p-type semiconductor layer 17p is formed of amorphous silicon, from the viewpoint of suppressing the impurity diffusion or decreasing a series resistance. In addition, the p-type amorphous silicon carbide layer and the p-type amorphous silicon oxide layer are a low-refractive index layer with a wide gap, which is preferable from the viewpoint of reducing an optical loss.

The n-type semiconductor layer 17n is formed of a silicon layer to which an n-type dopant (phosphorus or the like) is added. Note that, as with the p-type semiconductor layer 17p, it is preferable that the n-type semiconductor layer 17n is formed of an amorphous silicon layer.

The electrode layers 11 individually cover the p-type semiconductor layer 17p and the n-type semiconductor layer 17n, and thus, are electrically connected to the semiconductor layers 17p and 17n. Accordingly, the electrode layers 11 function as a transport layer that guides a carrier generated in the p-type semiconductor layer 17p or the n-type semiconductor layer 17n.

The electrode layers 11 are formed as a multilayer, and transparent oxide electrode layers 12 (12p and 12n) containing a transparent conductive oxide as a main component are formed as layers that are individually directly in contact with the p-type semiconductor layer 17p and the n-type semiconductor layer 17n. Note that, the "main component" indicates that the content of the substance is greater than or equal to 51 weight%, is preferably greater than or equal to 70 weight%, and is more preferably 90 weight%. In addition, unless the function of the transparent oxide electrode layer 12 is lost, substances other than the main component may be contained. In addition, the transparent oxide electrode layer 12 may be a single layer or a multilayer.

The material of the transparent conductive oxide is not particularly limited, but examples of the material include zinc oxide or indium oxide, or a material in which various metal oxides, for example, titanium oxide, tin oxide, tungsten oxide, molybdenum oxide, and the like are added to indium oxide at greater than or equal to 1 weight% and less than or equal to 10 weight%. In addition, a doping agent such as Sn, W, As, Zn, Ge, Ca, Si, and C may be added to such a material.

In addition, it is desirable that the thickness of the transparent oxide electrode layer 12 is greater than or equal to 10 nm and less than or equal to 140 nm, and examples of a forming method of the transparent oxide electrode layer 12 that is suitable for such a film thickness include a physical vapor deposition (PVD) method such as a sputtering method, a chemical vapor deposition (MOCVD) method using a reaction between an organic metal compound and oxygen or water, or the like.

Note that, the shape of the transparent oxide electrode layer 12p is an approximately rectangular shape that is identical to the shape of the p-type semiconductor layer 17p, but is formed to be smaller than the area of the p-type semiconductor layer 17p. Furthermore, the transparent oxide electrode layer 12p is formed such that a region [region] that is not covered with the transparent oxide electrode layer 12p is formed on one end side E1S and the other end side E2S, one end side E1S being one of the facing sides E1 and E2 of the semiconductor substrate 15, the other end side E2S being the other of the facing sides.

In addition, the shape of the transparent oxide electrode layer 12n is the approximately rectangular shape that is identical to the shape of the n-type semiconductor layer 17n, but is formed to be smaller than the area of the n-type semiconductor layer 17n. Furthermore, the transparent oxide electrode layer 12n is formed such that a region [region] that is not covered with the transparent oxide electrode layer 12n is generated on one end side E1S and the other end side E2S of the semiconductor substrate 15.

Such a transparent oxide electrode layer 12, for example, is formed by using a lift-off method that is a partial coating method of a film mask. That is, in a case where a film mask having a patterned opening is used, the transparent oxide electrode layer 12 is formed in a portion overlapping the opening, and the transparent oxide electrode layer 12 is formed immediately below a non-opening portion, a conductive region in which the transparent oxide electrode layer 12 is formed and a region (a non-conductive region) in which the transparent oxide electrode layer is not formed are formed.

Note that, the film formation of the transparent oxide electrode layer 12 is not limited to the lift-off method, and for example, may be a method of directly preparing a pattern by forming a film through a perforated metal such as a stencil mask, a method of forming the transparent oxide electrode layer 12 on the entire semiconductor layer 17, and then of removing the transparent oxide electrode layer 12 by partial etching (a subtractive method), or a method of directly applying a transparent electrode material only to a conductive region, and of forming a conductive layer (an additive method).

The electrode layer 11 includes, in addition to a transparent oxide electrode layer for the p-type semiconductor layer 17p [a transparent oxide electrode layer for p-type] 12p and a transparent oxide electrode layer for the n-type semiconductor layer 17n [a transparent oxide electrode layer for n-type] 12n, the metal electrode layers 13 [a metal electrode layer for p-type 13p and a metal electrode layer for n-type 13n] are formed for each of the layers 12p and 12n.

The metal electrode layer 13 is formed by directly stacking at least a part thereof on the surface side of the transparent oxide electrode layer 12, and is electrically connected to the transparent oxide electrode layer 12. However, the present invention is not limited thereto, but another layer may be interposed between both of the layers 12 and 13 insofar as the metal electrode layer 13 is electrically connected to the transparent oxide electrode layer 12.

The material of the metal electrode layer 13 is not particularly limited, but examples of the material include silver, copper, aluminum, nickel, or the like. In addition, a conductive paste containing such a metal material and a binder resin may be the material of the metal electrode layer 13.

Such a material is a light shielding material, and thus, the metal electrode layer 13 that is disposed on the light reception side of the solar cell 10 is formed into the shape of a thinned pattern. For example, as illustrated in Fig. 3, a comb-tooth type metal electrode layer 13p is exemplified.

In such a comb-tooth type metal electrode layer 13p, a portion that is a comb back is referred to as a bus bar part BB, portions in which comb teeth are arranged along the length of the comb back while intersecting with (orthogonal to) the comb back are referred to as finger parts FG.

Note that, in Figs. 3 and 4, the bus bar part BB is formed along a side on one end side E1 (a long side direction) of the semiconductor substrate 15, and the finger parts FG extend along a short side direction (the short sides E3 and E4) intersecting with the long side direction and arranged along the long side direction, but the present invention is not limited thereto. In addition, the bus bar part BB extends from terminals of a plurality of finger parts FG on the surface of the transparent oxide electrode layer 12p, and reaches the p-type semiconductor layer 17p, but the present invention is not limited thereto.

On the other hand, even in a case where the metal electrode layer 13n is disposed on the backside of the solar cell 10 on which light is not directly incident, the semiconductor substrate 15 is not shielded from light. For this reason, the metal electrode layer 13n, for example, as illustrated in Fig. 3, has a planar shape having approximately the same size as that of the transparent oxide electrode layer 12n, and is formed to fall within the area of the transparent oxide electrode layer 12n. However, the metal electrode layer is not limited to such a planar electrode in a rectangular shape, but may be a comb-tooth type metal electrode layer even on the backside, as with the light reception side.

In addition, it is desirable that the thickness of the metal electrode layers 13p and 13n is greater than or equal to 20 µm and less than or equal to 80 µm, and examples of a forming method of the metal electrode layer 13 that is suitable for such a film thickness include a printing method of performing ink jet printing or screen printing with respect to a conductive paste, or a plating method. However, the present invention is not limited thereto, but in the case of adopting a vacuum process, a vapor deposition method or a sputtering method may be adopted.

Note that, in a state in which the intrinsic semiconductor layer 16, the conductivity type semiconductor layer 17, and the electrode layer 11 are laminated on the semiconductor substrate 15, an annealing treatment is performed in order for the passivation of each junction interface, and for the suppression of the occurrence of a defect level on the semiconductor layer and the interface thereof.

Examples of the annealing treatment include a heating treatment in which a semiconductor substrate 15 on which each layer is disposed is put into an oven that is heated at higher than or equal to 150°C and lower than or equal to 200°C. In this case, the atmosphere in the oven may be the atmospheric air, but more effective annealing treatment is performed by using hydrogen or nitrogen. In addition, the annealing treatment may be rapid thermal annealing (RTA) treatment in which the semiconductor substrate 15 on which each layer is disposed is irradiated with an infrared ray by using an infrared heater.

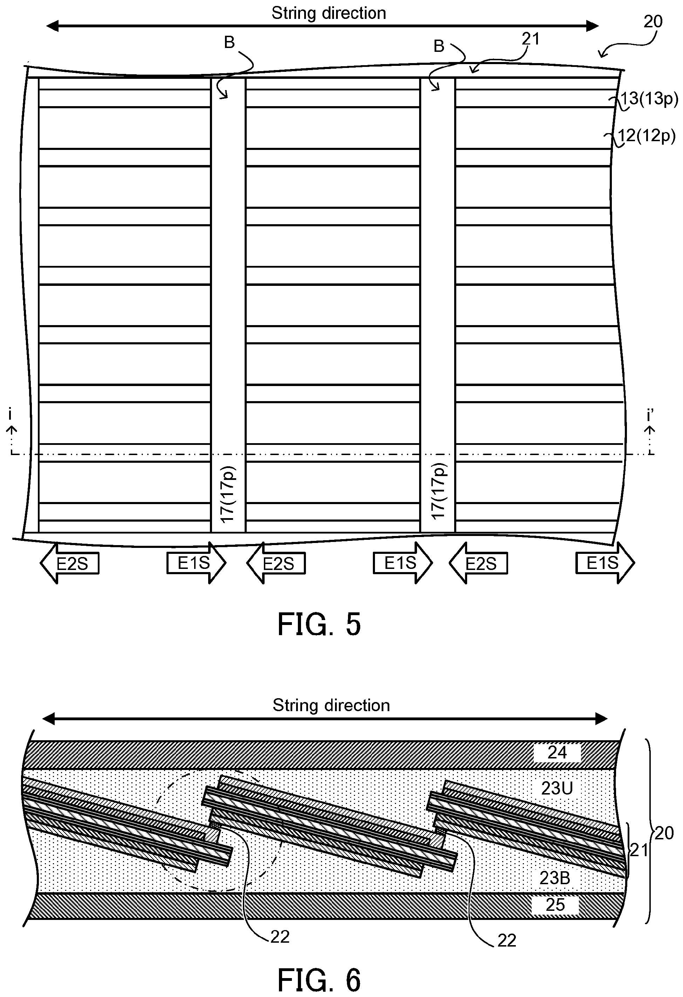

As illustrated in a plan view of Fig. 5 and Fig. 6 that is a sectional view taken along line i-i' of Fig. 5, a plurality of the double-sided electrode type solar cells 10 are mounted, and thus, a solar cell module 20 is obtained. The solar cell module 20 includes at least at least two solar cells 10, a conductive adhesive agent 22, a sealing material 23 (a light reception side sealing material 23U and a backside sealing material 23B), a light reception side protective member 24, and a backside protective member 25.

It is sufficient that at least two solar cells 10 are included in the solar cell module 20, and the solar cells 10 are at least electrically connected through the conductive adhesive agent 22. As described above, the plurality of solar cells 10 connected in to the shape of a string is referred to as a solar cell string 21.

Then, in the solar cell string 21, in a case where a part of a first solar cell 10 on one surface side at one end side E1S (for example, the light receiving surface 15SU side) overlaps a part of a second solar cell 10 on the other surface side at the other end side E2S (for example, the back surface 15SB side), the conductive adhesive agent 22 is interposed between the parts. For example, the conductive adhesive agent 22 is interposed between the bus bar part BB that is a part of the metal electrode layer 13p of the first solar cell 10 and a part of the metal electrode layer 13n of the second solar cell 10, and thus electrically connects the solar cells 10. Then, the solar cell module 20 includes one or more solar cell strings 21.

Note that, in the present specification, the "first solar cell" and the "second solar cell" indicate one and the other of two adjacent solar cells 10 and 10, in the solar cell string 21 formed of a plurality of solar cells 10.

Therefore, for example, in the solar cell string 21 formed of three solar cells 10, two sets of the "first solar cell" and the "second solar cell" are formed, and the solar cell 10 positioned in the center of three arranged solar cells 10 is the "second solar cell 10" in a case where the adjacent solar cell is the "first solar cell 10" on the other end side E2S (or one end side E1S), and is the "first solar cell 10" in a case where the adjacent solar cell is the "second solar cell 10" on one end side E1S (or the other end side E2S). That is, one solar cell 10 may be the "first solar cell", or may be the "second solar cell".

In addition, in a case where a part of the first solar cell 10 on one surface side at one end side E1S (for example, the light receiving surface 15SU side) overlaps a part of the second solar cell 10 on the other surface side at the other end side E2S (for example, the back surface 15SB side), a deposition structure is formed in which a plurality of solar cells 10 are uniformly inclined in a certain direction as with a tiled roof. From such an overview, a method in which the solar cells 10 are electrically connected as described above is referred to as a singling method.

Note that, examples of the conductive adhesive agent 22 include a conductive adhesive paste. Such a conductive adhesive agent paste, for example, is a paste-like adhesive agent in which conductive particles are dispersed in a thermosetting adhesive resin material such as an epoxy resin, an acrylic resin, or a urethane resin. However, the present invention is not limited thereto, and for example, a conductive adhesive film or an anisotropic conductive film that is formed into the shape of a film by dispersing conductive particles in a thermosetting adhesive resin material may be used.

The sealing material 23 seals and protects the solar cell 10, and is interposed between the surface of the solar cell 10 on the light reception side and the light reception side protective member 24, and between the surface of the solar cell 10 on the backside and the backside protective member 25. In the following description, the sealing material 23 covering the light reception side of the solar cell 10 may be referred to as the light reception side sealing material 23U, and the sealing material 23 covering the backside of the solar cell 10 may be referred to as the backside sealing material 23B in some cases.

The shapes of the light reception side sealing material 23U and the backside sealing material 23B are not particularly limited, and examples of the shapes include a sheet shape. This is because in the sheet shape, the surface and the back surface of the planar solar cell 10 are easily covered.

The material of the sealing material 23 is not particularly limited, but it is preferable that the material has properties of transmitting light (light transmissive properties). In addition, the material of the sealing material 23 has adhesive properties of allowing the solar cell 10, the light reception side protective member 24, and the backside protective member 25 to adhere with one another.

Examples of such a material include a light transmissive resin such as an ethylene/vinyl acetate copolymer (EVA), an ethylene/α-olefin copolymer, ethylene/vinyl acetate/triallyl isocyanurate (EVAT), polyvinyl butyrate (PVB), an acrylic resin, a urethane resin, or a silicone resin. Note that, the material of the light reception side sealing material 23U and the material of the backside sealing material 23B may be identical to each other, or may be different from each other.

The light reception side protective member 24 covers the surface of the solar cell 10 (the light receiving surface) through the light reception side sealing material 23U, and protects the solar cell 10. The shape of the light reception side protective member 24 is not particularly limited, but a plate shape or a sheet shape is preferable from the viewpoint of indirectly cover the planar light receiving surface.

The material of the light reception side protective member 24 is not particularly limited, but as with the sealing material 23, a material resistant to ultraviolet light while having light transmissive properties is preferable, and examples of the material include glass, or a transparent resin such as an acrylic resin or a polycarbonate resin. In addition, the surface of the light reception side protective member 24 may be processed into a depression-protrusion shape, or may be covered with an antireflection coating layer. This is because the light reception side protective member 24 above is less likely to reflect received light, and thus, guides more light to the solar cell 10.

The backside protective member 25 covers the back surface of the solar cell 10 through the backside sealing material 23B, and protects the solar cell 10. The shape of the backside protective member 25 is not particularly limited, but a plate shape or a sheet shape is preferable from the viewpoint of indirectly covering the planar back surface, as with the light reception side protective member 24.

The material of the backside protective member 25 is not particularly limited, but a material preventing the infiltration of water or the like (having high water barrier properties) is preferable. Examples of the material include a laminated body of a resin film such as polyethylene terephthalate (PET), polyethylene (PE), an olefin-based resin, a fluorinecontaining resin, or a silicone-containing resin, and a metal foil such as an aluminum foil.

Note that, a manufacturing method of the solar cell module 20 is not particularly limited. For example, the backside protective member 25, the backside sealing material 23B, the solar cell 10 (the solar cell string 21), the light reception side sealing material 23U, and the light reception side protective member 24 are overlapped in this order, are heated and pressurized at a predetermined temperature and a predetermined pressure, and thus, are sealed, by using a laminator or the like performing evacuation.

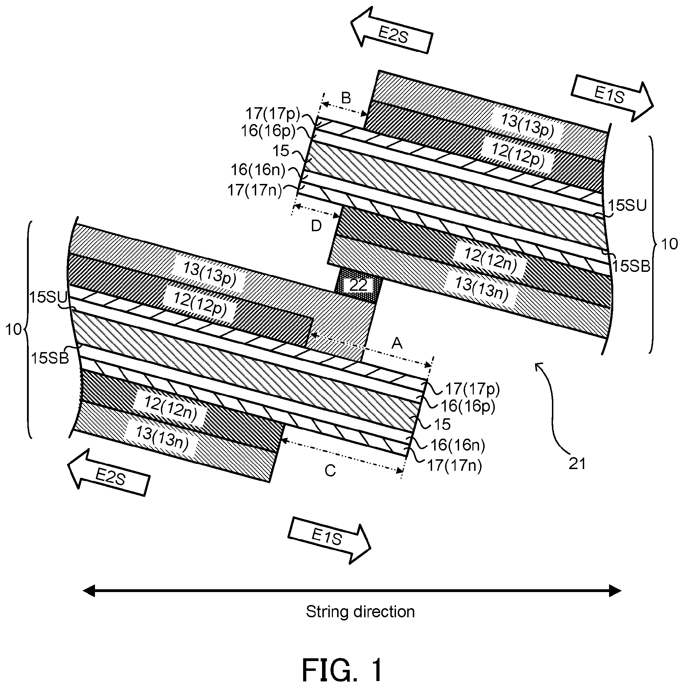

The solar cell string 21 that is used in the solar cell module 20 as described above will be described in detail by using Figs. 3 and 4, in addition to Fig. 1 that is an enlarged view of a circle portion with a dashed line of Fig. 6.

As illustrated in Figs. 3 and 4, the solar cell 10 of the solar cell string 21 includes the semiconductor substrate 15, and the p-type semiconductor layer 17p and the transparent oxide electrode layer for p-type 12p corresponding to the p-type semiconductor layer 17p, for example, on the light receiving surface 15SU side [the light receiving surface side] that is one surface side of the major surfaces 15S of the semiconductor substrate 15. In addition, the solar cell 10 includes the n-type semiconductor layer 17n and the transparent oxide electrode layer for n-type 12n corresponding to the n-type semiconductor layer 17n, for example, on the back surface 15SB side [the back surface side] that is the other surface side of the major surface 15S of the semiconductor substrate 15.

Then, in such a solar cell 10, in a case where one of both of the facing sides E1 and E2 in the semiconductor substrate 15 is defined as one end side E1S, and the other is defined as the other end side E2S, on the light receiving surface 15SU side at one end side E1S, a region that is not covered with the transparent oxide electrode layer for p-type 12p is defined as a "region A", and on the light receiving surface 15SU side at the other end side E2S, a region that is not covered with the transparent oxide electrode layer for p-type 12p is defined as a "region B". Then, the area of the region A is larger than the area of the region B.

Note that, in the solar cell module 20, in a case where a part of the first solar cell 10 on the light receiving surface 15SU side that one surface side at one end side E1S overlaps a part of the second solar cell 10 on the back surface 15SB side that is the other surface side at the other end side E2S, the conductive adhesive agent 22 is interposed between the parts and electrically connects both of the solar cells 10. Then, the region A is shielded by the second solar cell 10.

In the solar cell 10, pn junction exhibiting a photovoltaic effect occurs on the major surface 15SU of the semiconductor substrate 15 on which the p-type semiconductor layer 17p is formed, in the case of the n-type semiconductor substrate 15. Therefore, passivation between the major surface 15SU and the transparent oxide electrode layer for p-type 17p is important.

However, in the solar cell module 20 adopting the singling method, as illustrated in Fig. 1, one end side E1S of both facing sides in one solar cell 10 is shielded by the other end side E2S of both of the facing sides in another solar cell 10. In such a shielded portion, a dark current may be generated. Furthermore, in an end portion of the semiconductor substrate 15, the recombination of the carrier is more likely to occur, and a dark current is also easily generated, compared to the central portion of the semiconductor substrate 15, due to film formation around a side opposite to a film formation surface of the p-type semiconductor layer 17p or the n-type semiconductor layer 17n, a mechanical damage, or the like.

However, in the solar cell module 20 adopting the singling method, in a case where the region A is disposed in the end portion of the semiconductor substrate 15 that is a light shielding region due to the overlap of the solar cell 10, the region A is designed to be wide. For this reason, even in a case where a dark current is generated in pn junction in the region A, there is no transparent oxide electrode layer for p-type, and thus, the dark current is not collected. As a result thereof, a decrease in an operating point voltage of the solar cell module 20 due to the dark current is less likely to occur, and the output of the solar cell module 20 does not decrease.

In addition, most of the collection of the carriers generated in the semiconductor substrate 15 is performed by the transparent oxide electrode layer for p-type 12p, and thus, it is preferable that the area of the transparent oxide electrode layer for p-type 12p is large except for the region A. For this reason, in the solar cell 10, it is preferable that the length of the region B along a direction connecting one end side E1S to the other end side E2S is less than 2 times the thickness of the semiconductor substrate 15 (note that, in Fig. 4, the direction is a direction parallel to the sides E3 and E4 of the semiconductor substrate 15, and the direction is referred to as a string direction from a direction in which the solar cell 10 forms the solar cell string 21).

Therefore, the solar cell module 20 on which the solar cell 10 is mounted improves the output while suppressing the influence of a dark current.

In addition, in the solar cell 10, for example, on the back surface 15SB side that is the other surface side at the other end side E2S, in a region of the n-type semiconductor layer 17n that is not covered with the transparent oxide electrode layer for n-type 12n, a region facing the region B with the semiconductor substrate 15 as a boundary is defined as a "region D". Then, it is preferable that the area of the region D is smaller than or equal to the area of the region B.

In the solar cell 10, a potential difference between the transparent oxide electrode layer for n-type 17n and the semiconductor substrate 15 is less than a potential difference between the transparent oxide electrode layer for p-type 17p and the semiconductor substrate 15. For this reason, even in a case where a dark current is generated, the current is less likely to flow through the transparent oxide electrode layer for n-type 12n. Therefore, the region D may be narrow (that is, the transparent oxide electrode layer for n-type 12n may be wide). Note that, it is sufficient that the area of the region D is smaller than or equal to the area of the region B, and thus, the region D may not exist.

In addition, in the solar cell 10, for example, on the back surface 15SB side that is the other surface side at one end side E1S, in a region of the n-type semiconductor layer 17n that is not covered with the transparent oxide electrode layer for n-type 12n, a region facing the region A with the semiconductor substrate 15 as a boundary is defined as a "region C". Then, it is preferable that the area of the region C is larger than the area of the region B.

In the solar cell module 20 adopting the singling method, in a case where the region A is disposed in the end portion of the semiconductor substrate 15 that is the light shielding region due to the overlap of the solar cell 10, the conductive adhesive agent 22 is disposed in the region A or in the vicinity thereof by coating or the like. For this reason, in the connection of the solar cells 10, the conductive adhesive agent 22 may not only spread to the region A, but also wrap around the region C positioned on a side opposite to the over the region A, over the end portion of the semiconductor substrate 15.

However, the region C is designed to be wide, and thus, even in a case where the conductive adhesive agent 22 extends to the region C, the conductive adhesive agent 22 is less likely to contact with the transparent oxide electrode layer for n-type 12n. Therefore, a leakage due to the conductive adhesive agent 22 that bridges a gap between one end side E1S of the transparent oxide electrode layer for p-type 12p and one end side E1S of the transparent oxide electrode layer for n-type 12n is less likely to occur.

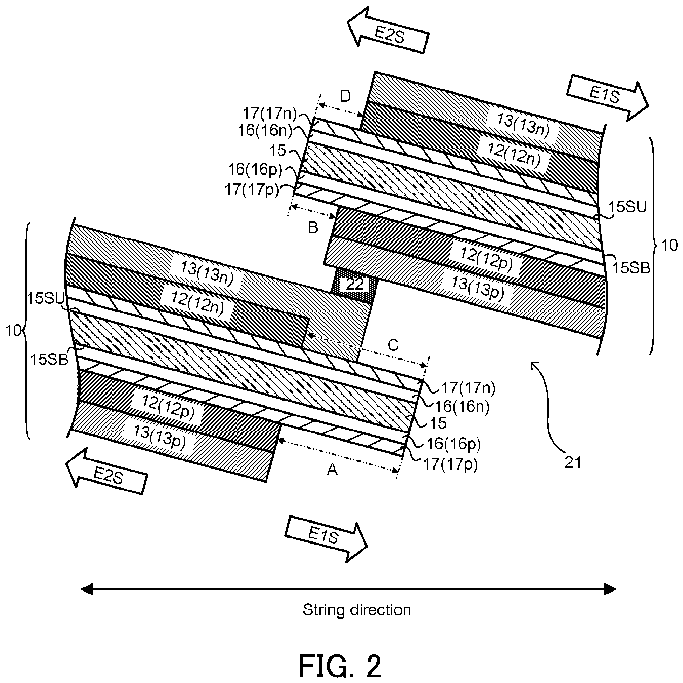

Note that, the region A to the region D described above are not limited to the solar cell module 20 in which the p-type semiconductor layer 17p is disposed on the light reception side, and the n-type semiconductor layer 17n is disposed on the backside, as illustrated in Fig. 1. That is, the same applies to the solar cell module 20 using the solar cell 10 in which the n-type semiconductor layer 17n is disposed on the light reception side, and the p-type semiconductor layer 17p is disposed on the backside, as illustrated in Fig. 2.

In the solar cell module 20 as illustrated in Fig. 2, in a case where a part of the first solar cell 10 on the light receiving surface 15SU side that is one surface side at one end side E1S overlaps a part of the second solar cell 10 on the back surface 15SB side that is the other surface side at the other end side E2S, the conductive adhesive agent 22 is interposed between the parts, and electrically connects both of the solar cells 10. Then, the region C is shielded by the second solar cell 10.

The solar cell 10 in the solar cell module 20 also includes the semiconductor substrate 15, the p-type semiconductor layer 17p and the transparent oxide electrode layer for p-type 12p corresponding to the p-type semiconductor layer 17p, for example, on the back surface 15SB side that is one surface side of the major surfaces 15S of the semiconductor substrate 15. In addition, the solar cell 10 includes the n-type semiconductor layer 17n and the transparent oxide electrode layer for n-type 12n corresponding to the n-type semiconductor layer 17n, for example, on the light receiving surface 15SU side that is the other surface side of the major surfaces 15S of the semiconductor substrate 15.

Then, in such a solar cell 10, in a case where one of both of the facing sides E1 and E2 in the semiconductor substrate 15 is defined as one end side E1S, and the other is defined as the other end side E2S, on the back surface 15SB side at one end side E1S, in a region of the p-type semiconductor layer 17p that is not covered with the transparent oxide electrode layer for p-type 12p is defined as a "region A", and on the back surface 15SB side at the other end side E2S, a region of the p-type semiconductor layer 17p that is not covered with the transparent oxide electrode layer for p-type 12p is defined as a "region B". Then, the area of the region A is larger than the area of the region B.

In the solar cell module 20 on which such a solar cell 10 is mounted, even in a case where a dark current is generated in pn junction of the region A on the back surface 15SB side, there is no transparent oxide electrode layer for p-type, and thus, the dark current is not collected. As a result thereof, a decrease in the operating point voltage of the solar cell module 20 due to the dark current is less likely to occur, and the output of the solar cell module 20 does not decrease.

In addition, in the solar cell 10 of the solar cell module 20 as illustrated in Fig. 2, it is preferable that the length of the region B along the direction connecting one end side E1S to the other end side E2S (the string direction) is less than 2 times the thickness of the semiconductor substrate 15.

This is because in such a solar cell 10, that is, the p-type semiconductor layer 17p is disposed on the back surface 15SB side, and thus, even in a case where a pn junction surface is not directed towards the light reception side, most of the collection of the carriers generated in the semiconductor substrate 15 is performed by the transparent oxide electrode layer for p-type 12p, and therefore, it is preferable that the area of the transparent oxide electrode layer for p-type is large except for the region A.

In addition, in the solar cell 10 of the solar cell module 20 as illustrated in Fig. 2, for example, on the light receiving surface 15SU side that is the other surface side at the other end side E2S, in a region of the n-type semiconductor layer 17n that is not covered with the transparent oxide electrode layer for n-type 12n, a region facing the region B with the semiconductor substrate 15 as a boundary is defined as a "region D". Then, it is preferable that the area of the region D is smaller than or equal to the area of the region B.

In such a solar cell 10, a potential difference between the transparent oxide electrode layer for n-type 12n and the semiconductor substrate 15 is less than a potential difference between the transparent oxide electrode layer for p-type 12p and the semiconductor substrate 15, and thus, a dark current is less likely to flow through the transparent oxide electrode layer for n-type 12n, and the region D may be narrow.

Note that, it is sufficient that the area of the region D is smaller than or equal to the area of the region B, and thus, the region D may not exist. That is, the entire other end side E2S on the light receiving surface 15SU side may be covered with the transparent oxide electrode layer for n-type 12n. Therefore, the transparent oxide electrode layer for n-type 12n, for example, is capable of exhibiting the function of an antireflection layer, and thus, the appearance of the solar cell module 20 is improved.

In addition, in the solar cell 10 of the solar cell module 20 as illustrated in Fig. 2, for example, on the light receiving surface 15SU side that is the other surface side at one end side E1S, in a region of the n-type semiconductor layer 17n that is not covered with the transparent oxide electrode layer for n-type 12n, a region facing the region A with the semiconductor substrate 15 as a boundary is defined as a "region C". Then, it is preferable that the area of the region C is larger than the area of the region B.

In the solar cell module 20 adopting the singling method, in a case where the region C is disposed in the end portion of the semiconductor substrate 15 that is the light shielding region due to the overlap of the solar cell 10, the conductive adhesive agent 22 is disposed in the region C or in the vicinity thereof. For this reason, in the connection of the solar cells 10, the conductive adhesive agent 22 may not only spread to the region C, but also wrap around the region A positioned on a side opposite to the region C, over the end portion of the semiconductor substrate 15.

However, the region C is designed to be wide, and thus, the conductive adhesive agent 22 wraps around the region C to the region A, and thus, is less likely to advance to the p-type semiconductor layer 17p. Therefore, a leakage due to the conductive adhesive agent 22 that bridges a gap between one end side E1S of the transparent oxide electrode layer for p-type 12p and one end side E1S of the transparent oxide electrode layer for n-type 12n is less likely to occur.

Note that, as illustrated in Fig. 1, in a case where the solar cell module 20 is formed of the solar cell 10 in which the p-type semiconductor layer 17p is disposed on the light receiving surface 15SU side that is one surface, and the n-type semiconductor layer 17n is disposed on the back surface 15SB side that is the other surface side, in the solar cell 10, it is preferable that at least a part of the region A is covered with a part of the metal electrode layer for p-type 13p that is electrically connected to the transparent oxide electrode layer for p-type 12p, from the viewpoint of preventing the leakage between the p-type semiconductor layer 17p and the n-type semiconductor layer 17n.

Therefore, a part of the metal electrode layer for p-type 13p extends to the region A, that is, the end of the semiconductor substrate 15 on one end side E1S, and thus, the conductive adhesive agent 22 can be disposed in the portion. Then, in a case where the region A is covered with the solar cell 10, the conductive adhesive agent 22 is hidden by the solar cell 10. As a result thereof, in the solar cell module 20, the conductive adhesive agent 22 does not protrude to the light receiving surface 15SU side over a shielding region, and thus, a shadow loss due to the conductive adhesive agent 22 is suppressed.

Note that, the region A is shielded by the second solar cell 10, and thus, a part of the metal electrode layer for p-type 13p that extends to the region A is also covered with the solar cell 10.

In addition, in such a solar cell 10 of the solar cell module 20, it is preferable that the area of the metal electrode layer for n-type 13n that is electrically connected to the transparent oxide electrode layer for n-type 12n by covering the transparent oxide electrode layer for n-type 12n is smaller than or equal to the area of the transparent oxide electrode layer for n-type 13n, and does not overlap the region C.

Therefore, a part of the region C on an opposite side of the region A is not covered with a part of the metal electrode layer for n-type 13p. Then, for example, even in a case where the conductive adhesive agent 22 spreads to the region A, and wraps around the region C over the end portion of the semiconductor substrate 15, the conductive adhesive agent is less likely to reach the metal electrode layer for n-type 13n. For this reason, a leakage due to the conductive adhesive agent 22 that bridges a gap between one end side E1S of the metal electrode layer for p-type 13p and one end side E1S of the metal electrode layer for n-type 13n is less likely to occur.

In addition, from the viewpoint of preventing the leakage as described above, as illustrated in Fig. 2, in the solar cell module 20 including the solar cell 10 in which the n-type semiconductor layer 17n is disposed on the light receiving surface 15SU side that is the other surface, and the p-type semiconductor layer 17p is disposed on the back surface 15SB side that is one surface side, it is preferable to adopt the same configuration as described above. That is, in such a solar cell 10, it is preferable that a part of the region C is covered with a part of the metal electrode layer for n-type 13n that is electrically connected to the transparent oxide electrode layer for n-type 12n.

Therefore, a part of the metal electrode layer for n-type 13n extends to the region C, that is, the end of the semiconductor substrate 15 on one end side E1S, and thus, the conductive adhesive agent 22 can be disposed in the portion. Then, in a case where the region C is covered with the solar cell 10, the conductive adhesive agent 22 is hidden by the solar cell 10, and a shadow loss due to the conductive adhesive agent 22 is suppressed, similarly to the above.

Note that, the region C is shielded by the second solar cell 10, and thus, a part of the metal electrode layer for n-type 13n that extends to the region C is also covered with the solar cell 10.

In addition, in such a solar cell 10 of the solar cell module 20, it is preferable that the area of the metal electrode layer for p-type 13p that is electrically connected to the transparent oxide electrode layer for p-type 12p by covering the transparent oxide electrode layer for p-type 12p is smaller than or equal to the area of the transparent oxide electrode layer for p-type 12p, and does not overlap the region A.

Therefore, a part of the region A on an opposite side of the region C is not covered with a part of the metal electrode layer for p-type 13p. For this reason, for example, even in a case where the conductive adhesive agent 22 spreads to the region C, and wraps around the region A over the end portion of the semiconductor substrate 15, the conductive adhesive agent is less likely to reach the metal electrode layer for p-type 13p. For this reason, a leakage due to the conductive adhesive agent 22 that bridges a gap between one end side E1S of the metal electrode layer for n-type 13n and one end side E1S of the metal electrode layer for p-type 13p is less likely to occur.

Note that, the present invention is not limited to the embodiment described above, and various changes can be made within the scope of the claims. That is, embodiments obtained by combining technical means that are suitably changed within the scope of the claims are also included in the technical scope of the present invention.

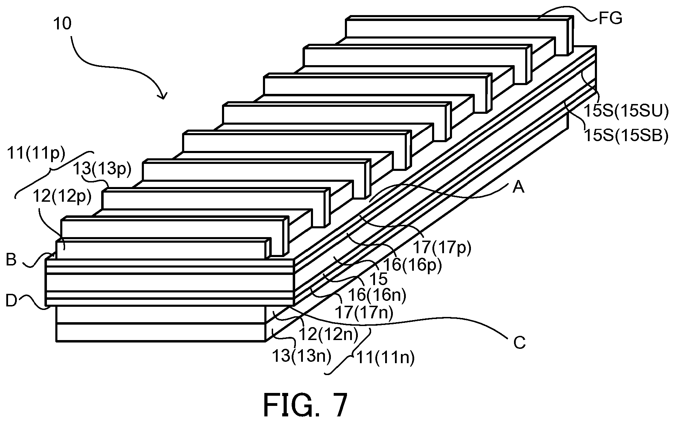

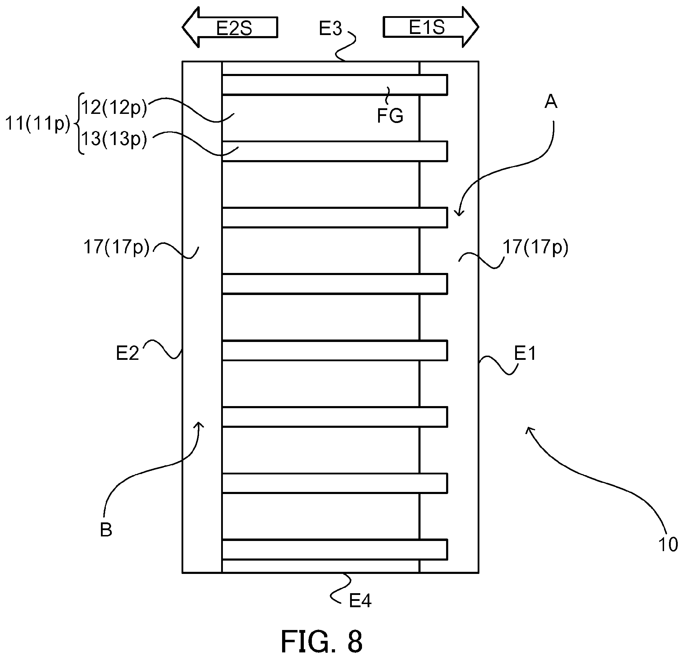

For example, in the above description, an example in which the bus bar part BB and the finger part FG are provided in the metal electrode layers 13 (13p and 13n) on the light receiving surface 15SU side has been described, but the present invention is not limited thereto. For example, as illustrated in a perspective view of Fig. 7 and a plan view of Fig. 8, the metal electrode layer 13p may include only the finger part FG. In this case, the conductive adhesive agent 22 may be disposed in the position of the bus bar part BB illustrated in Fig. 3, instead of the bus bar part BB.

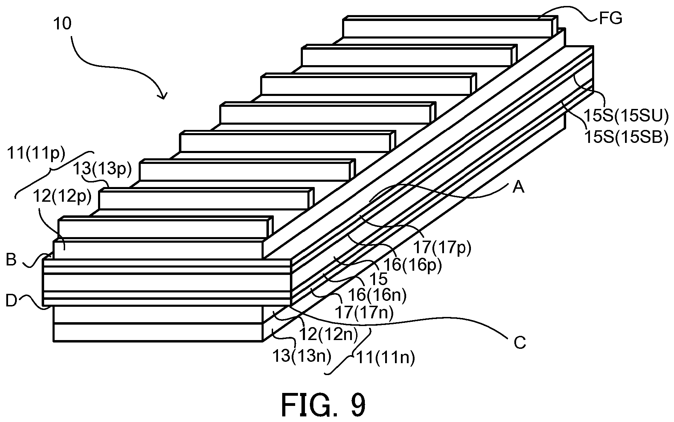

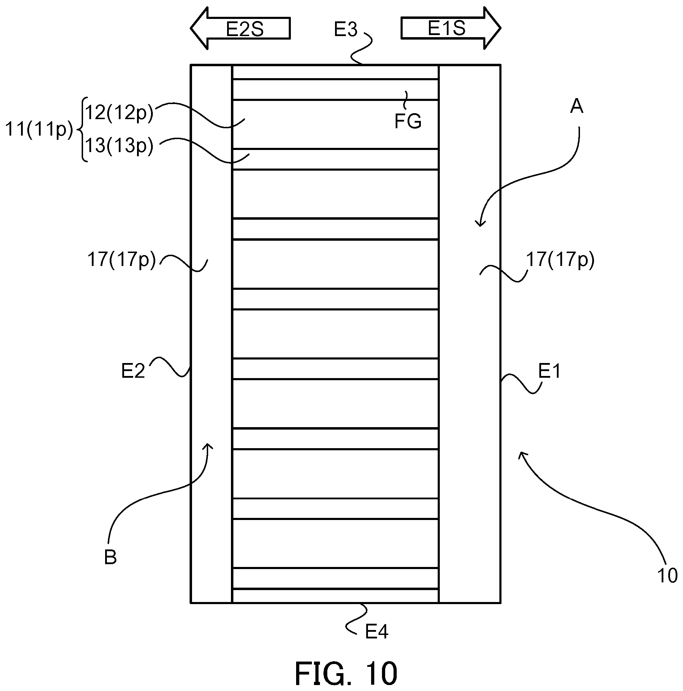

In addition, in the above description, an example in which a part of the finger part FG extends to the surface of the conductivity type semiconductor layer 17 over the transparent oxide electrode layer 12 has been described, but the present invention is not limited thereto. For example, as illustrated in a perspective view of Fig. 9 and a plan view of Fig. 10, the finger part FG may fall within the surface of the transparent oxide electrode layer 12. In this case, the conductive adhesive agent 22 may be disposed to connect the respective finger parts FG, and may be used instead of the bus bar part BB illustrated in Fig. 3. In addition, the conductive adhesive agent 22 that is used instead of the bus bar part BB may be disposed on the transparent oxide electrode layer 12, and may not be disposed on the conductivity type semiconductor layer 17.

In addition, in the above description, it has been described that the bus bar part BB, or the conductive adhesive agent 22 that is used instead of the bus bar part are in the shape of one line, but the present invention is not limited thereto, and the bus bar part BB or the conductive adhesive agent 22 may be in the shape of a plurality of lines, or may be in a non-linear shape.

### EXAMPLES

Hereinafter, the present invention will be described in detail by Examples; however, the present invention is not limited to these Examples.

First, in a plane orientation (100) of an incident surface, a 6-inch n-type monocrystalline silicon substrate having a thickness of 200 µm was washed with acetone, and then, was immersed in an aqueous solution of HF of 2 weight% for 5 minutes, a silicon oxide layer on the surface was removed, and rinsing with ultrapure water was performed twice. After that, the semiconductor substrate was immersed in an aqueous solution of KOH/isopropyl alcohol of 5/15 weight% that was retained at 75°C for 15 minutes. Next, the semiconductor substrate was immersed in an aqueous solution of HF of 2 weight% for 5 minutes, was rinsed with ultrapure water twice, and was dried at a normal temperature.

Note that, the surface of the dried semiconductor substrate was observed with an atomic force microscope (AFM), and as a result thereof, a texture structure in the shape of a quadrangular pyramid was formed on both surfaces, and arithmetic average roughness thereof was 2100 nm.

The surface of the monocrystalline silicon substrate in which the texture has been formed was immersed in an aqueous solution of HCl of 5% at 70°C for 5 minutes, and an alkaline component remaining on the surface was neutralized. After that, the surface was washed for 10 minutes by using ozone water of 15 ppm, and was immersed in an aqueous solution of HF of 5% for 2 minutes, and thus, an ozone oxide film was removed.

In Examples 1 and 2 and Comparative Example 1 described below, the semiconductor substrate described above was used. Specifically, a p-type semiconductor layer and an n-type semiconductor layer were formed on the semiconductor substrate, a transparent oxide electrode layer and a metal electrode layer were formed thereon, and the semiconductor substrate was divided at a desired position, by using laser. For this reason, an electrode layer was formed in accordance with a plurality of divided pieces formed from a large-sized semiconductor substrate. In addition, the divided pieces (solar cells) were connected by using a conductive adhesive agent, in a singling method, and thus, a solar cell string was obtained. Then, a solar cell module was prepared by using the solar cell string. Hereinafter, the details will be described.

### [Example 1]

First, a large-sized semiconductor substrate was introduced into a CVD device, an i-layer amorphous silicon layer of 4 nm was formed on one surface, as an intrinsic semiconductor layer, and a p-type amorphous silicon layer of 5 nm was formed thereon, as the p-type semiconductor layer.

As a film formation condition of the intrinsic semiconductor layer, a substrate temperature was 180°C, a pressure was 130 Pa, a flow ratio of SiH₄/H₂ was 2/10, and an input power density was 0.03 W/cm².

As a film formation condition of the p-type semiconductor layer, a substrate temperature was 190°C, a pressure was 130 Pa, a flow ratio of SiH₄/H₂/B₂H₆ was 1/10/3, and an input power density was 0.04 W/cm². Note that, gas in which the concentration of B₂H₆ was diluted by H₂ to 5000 ppm was used as B₂H₆ gas described above.

Next, an i-layer amorphous silicon layer of 5 nm was formed on the other surface of the semiconductor substrate, as the intrinsic semiconductor layer, and an n-type amorphous silicon layer of 10 nm was formed thereon, as the n-type semiconductor layer. The film formation condition of the intrinsic semiconductor layer is as described above. As a film formation condition of the n-type semiconductor layer, a substrate temperature was 180°C, a pressure was 60 Pa, a flow ratio of SiH₄/PH₃ was 1/2, and an input power density was 0.02 W/cm². Note that, gas in which the concentration of PH₃ was diluted by H₂ to 5000 ppm was used as PH₃ gas described above.

Subsequently, the semiconductor substrate including the conductivity type semiconductor layer was sent to a sputtering chamber, an ITO layer of 120 nm was formed on the p-type semiconductor layer and the n-type semiconductor layer, as a transparent electrode layer. Note that, a region A to a region D were formed by a lift-off method using a film mask.

Specifically, in one solar cell, for example, on one end that is a side covered with another solar cell, the length of the regions A and C along a string direction connecting one end side to the other end side, from the end of the solar cell on one end side, was set to 1100 µm. On the other hand, in one solar cell, for example, on the other end that is a side covering another solar cell, the length of the regions B and D along a string direction connecting the other end side to one end side, from the end of the solar cell on the other end side, was set to 150 µm.

Note that, a flexible resin film formed of polypropylene was used as the film mask. In addition, a biaxially stretched film was used as the film mask, from the viewpoint of a strength, heat resistance, dimensional stability, or the like.

Subsequently, the semiconductor substrate including the transparent oxide electrode layer was sent to a printing chamber, and was coated with a silver paste by screen printing, and thus, a metal electrode layer was formed. Specifically, comb-tooth type metal electrode layers were formed on the transparent electrode layers on a light reception side and a backside. Note that, the metal electrode layer on the light reception side was approximately orthogonal to a finger part and a bus bar electrode. Note that, the width of the finger part of the light reception side was approximately 50 µm, an interval (a pitch) therebetween was approximately 1800 µm, the width of the finger part on the backside was approximately 50 µm, and an interval therebetween was approximately 500 µm.

Next, the semiconductor substrate including the electrode layer described above was sent to a laser chamber, and was cut by using a laser device, and thus, a solar cell having an approximately oblong shape was prepared. Note that, laser was incident from a formation surface side of the n-type semiconductor layer. In addition, the position of the laser was adjusted to a division position that was set at the time of forming the transparent oxide electrode layer.

Subsequently, the solar cell was sent to a dispenser chamber, the conductive adhesive agent was applied to the bus bar part in a region of a first solar cell to be superimposed, by using a dispenser, a second solar cell was overlapped with the first solar cell, and the first solar cell and the second solar cell were joined by thermal compression bonding. Such junction using the overlap was repeated by using a total of 34 solar cells. As a result thereof, a solar cell string was prepared in which 34 solar cells were electrically connected in series. Note that, as a thermal compression bonding condition, a temperature was 150°C, a time was 20 minutes, and a pressure was 5 MPa.

Subsequently, the solar cell string was sent to a sealing chamber, a light reception side sealing material, the solar cell string, a backside sealing material, and a backside protective member were laminated in this order, on a light reception side protective material, and the solar cell string was sealed, and thus, a solar cell module was prepared. Note that, 10 solar cell strings were arranged in 5 parallels × 2 series (a total of 340 solar cells), and thus, an assembly of the solar cell strings was obtained. In addition, modularization was performed such that the p-type semiconductor layer of each of the solar cells was directed towards the light reception side.

### [Example 2]

The p-type semiconductor layer was disposed on the light receiving surface side, and the n-type semiconductor layer was disposed on the back surface side in the solar cell module of Example 1 while in Example 2, the direction was reversed, that is, the n-type semiconductor layer was disposed on the light receiving surface side, and the p-type semiconductor layer was disposed on the back surface side. In addition, the length of the region A was 1100 µm, and the length of the region B was 150 µm, but the region C and the region D were not formed, that is, the transparent oxide electrode layer was formed on the entire surface of the n-type semiconductor layer on the light receiving surface side.

### [Comparative Example 1]

In Comparative Example 1, in the solar cell module of Example 1, only the transparent oxide electrode layer was changed. Specifically, the transparent oxide electrode layer was formed on the entire surface of the conductivity type semiconductor layer of the solar cell without using the film mask.

### [Evaluation]

Reference sunlight having an air mass (AM) of 1.5 was emitted at a light amount of 100 mW/cm², by a solar simulator, and in the solar cell modules of Examples 1 and 2 and Comparative Example 1, solar cell properties (an open voltage (Voc), a short-circuit current density (Isc), a fill factor (FF), and output (W) were measured (refer to Table 1).

**[Table 1]**

| | Open voltage (Voc) [V] | Short-circuit current density (Isc) [A] | Fill factor (FF) [%] | Output (Power) [W] |
|---|---|---|---|---|
| Example 1 | 50.116 | 9.205 | 77.02 | 355.300 |
| Example 2 | 50.022 | 9.022 | 76.87 | 346.913 |
| Comparative Example 1 | 49.640 | 9.225 | 73.71 | 337.535 |

From Table 1, it was determined that the output was higher in Example 1 and Example 2 than in Comparative Example 1. It is considered that this is because in both of the examples, a dark current of a shield portion of the solar cell due to the singling method was reduced, and thus, a diode loss in the solar cell was reduced, and thus, the fill factor (FF) was improved.

In addition, in Comparative Example 1, it is considered that the transparent oxide electrode layer is formed on the entire surface of the conductivity type semiconductor layer, and thus, it is considered that a leakage occurs due to the reattachment of a residue, and fusion droop of the transparent oxide electrode layer, at the time of being divided by laser irradiation. On the other hand, in both of the examples, a division portion of the laser irradiation is a region in which the transparent oxide electrode layer is not formed. For this reason, a leakage does not occur as with Comparative Example 1, and thus, it is considered that output properties are improved.

### EXPLANATION OF REFERENCE NUMERALS

10 SOLAR CELL [DOUBLE-SIDED ELECTRODE TYPE SOLAR CELL]
11 ELECTRODE LAYER
12 TRANSPARENT OXIDE ELECTRODE LAYER
12p TRANSPARENT OXIDE ELECTRODE LAYER for p-TYPE
12n TRANSPARENT OXIDE ELECTRODE LAYER for n-TYPE
13 METAL ELECTRODE LAYER
13p METAL ELECTRODE LAYER for p-TYPE
13n METAL ELECTRODE LAYER for n-TYPE
15 SEMICONDUCTOR SUBSTRATE
15S MAJOR SURFACE OF SEMICONDUCTOR SUBSTRATE
15SU MAJOR SURFACE OF SEMICONDUCTOR SUBSTRATE ON LIGHT RECEPTION SIDE [LIGHT RECEIVING SURFACE, ONE SURFACE SIDE/THE OTHER SURFACE SIDE]
15SB MAJOR SURFACE OF SEMICONDUCTOR SUBSTRATE ON BACKSIDE [BACK SURFACE, THE OTHER SURFACE SIDE/ONE SURFACE SIDE]
16 INTRINSIC SEMICONDUCTOR LAYER
17 SEMICONDUCTOR LAYER
17p p-TYPE SEMICONDUCTOR LAYER
17n n-TYPE SEMICONDUCTOR LAYER
20 SOLAR CELL MODULE [DOUBLE-SIDED ELECTRODE TYPE SOLAR CELL MODULE]
21 SOLAR CELL STRING
22 CONDUCTIVE ADHESIVE AGENT
23 SEALING MATERIAL
23U LIGHT RECEPTION SIDE SEALING MATERIAL
23B BACKSIDE SEALING MATERIAL
24 LIGHT RECEPTION SIDE PROTECTIVE MEMBER
25 BACKSIDE PROTECTIVE MEMBER
E1S ONE END SIDE/OTHER END SIDE
E2S OTHER END SIDE/ONE END SIDE
A REGION A
B REGION B
C REGION C
D REGION D

## Claims

1. A solar cell module (20), comprising:
at least one or more solar cell strings (21) that include at least two double-sided electrode type solar cells (10) that are electrically connected,
wherein the at least two double-sided electrode type solar cells (10) each comprise:
a semiconductor substrate (15);
a p-type semiconductor layer (17p) and a transparent oxide electrode layer (12p) for p-type corresponding to the p-type semiconductor layer (17p) on one surface side of major surfaces (15S) of the semiconductor substrate (15); and
an n-type semiconductor layer (17n) and a transparent oxide electrode layer (12n) for n-type corresponding to the n-type semiconductor layer (17n) on the other surface side of the major surfaces (15S) of the semiconductor substrate (15),
wherein when in the semiconductor substrate (15), one of facing sides is defined as one end side (E1S), and the other is defined as the other end side (E2S),
on the one surface side at the one end side (E1S), a region of the p-type semiconductor layer (17p) that is not covered with the transparent oxide electrode layer (12p) for p-type is defined as a "region A",
on the one surface side at the other end side (E2S), a region of the p-type semiconductor layer (17p) that is not covered with the transparent oxide electrode layer (12p) for p-type is defined as a "region B", and
wherein an area of the region A is larger than an area of the region B;
the solar cell module being **characterized in that**, a part of a first double-sided electrode type solar cell (10) on the one surface side (15SU) at the one end side (E1S) overlaps a part of a second double-sided electrode type solar cell (10) on the other surface side (15SB) at the other end side (E2S), a conductive adhesive agent (22) is interposed between the parts and electrically connects both of the double-sided electrode type solar cells (10), and further
wherein either the region A is shielded by the second double-sided electrode type solar cell (10), or
when on the other surface side (15S) at the one end side (E1S), in the region that is not covered with the transparent oxide electrode layer (12n) for n-type, the region facing the region A with the semiconductor substrate (15) as a boundary is defined as a "region C", the region C is shielded by the second double-sided electrode type solar cell (10).

2. The solar cell module according to claim 1, wherein in the at least two double-sided electrode type solar cells (10) a length of the region B along a direction connecting the one end side (E1S) to the other end side (E2S) is less than 2 times a thickness of the semiconductor substrate (15).

3. The solar cell module according to claim 1 or 2, wherein, in the at least two double-sided electrode type solar cells (10), when on the other surface side (15B) at the other end side (E2S), in a region of the n-type semiconductor layer (17n) that is not covered with the transparent oxide electrode layer (12n) for n-type, a region facing the region B with the semiconductor substrate (15) as a boundary is defined as a "region D",
an area of the region D is smaller than or equal to the area of the region B.

4. The solar cell module according to any one of claims 1 to 3, wherein, in the at least two double-sided electrode type solar cells (10), when on the other surface side (15B) at the one end side(E1S), in a region of the n-type semiconductor layer (17n) that is not covered with the transparent oxide electrode layer (12n) for n-type, a region facing the region A with the semiconductor substrate (15) as a boundary is defined as a "region C",
an area of the region C is larger than the area of the region B.

5. The solar cell module according to any one of claims 1 to 4, wherein, in the at least two double-sided electrode type solar cells (10), in a case where the one surface side (15S) is a light reception side, and the other surface side (15B) is a backside,
at least a part of the region A is covered with a part of a metal electrode layer (13p) for p-type that is electrically connected to the transparent oxide electrode layer (12p) for p-type.

6. The solar cell module according to claim 5, wherein, in the at least two double-sided electrode type solar cells (10), when on the other surface side (15S) at the one end side (E13), in a region that is not covered with the transparent oxide electrode layer (12n) for n-type, a region facing the region A with the semiconductor substrate (15) as a boundary is defined as a "region C",
an area of a metal electrode layer (13n) for n-type that is electrically connected to the transparent oxide electrode layer (12n) for n-type by covering the transparent oxide electrode layer (12n) for n-type is smaller than or equal to an area of the transparent oxide electrode layer (12n) for n-type, and does not overlap the region C.

7. The solar cell module according to any one of claims 1 to 4, wherein, in the at least two double-sided electrode type solar cells (10), in a case where the other surface side (15S) is a light reception side (15SU), and the one surface side (15SB) is a backside,
when on the other surface side (15S) at the one end side (E1S), in a region that is not covered with the transparent oxide electrode layer (12n) for n-type, a region facing the region A with the semiconductor substrate (15) as a boundary is defined as a "region C",
at least a part of the region C is covered with a part of a metal electrode layer (13n) for n-type that is electrically connected to the transparent oxide electrode layer (12n) for n-type.

8. The solar cell module according to claim 7, wherein, in the at least two double-sided electrode type solar cells (10), an area of a metal electrode layer (13p) for p-type that is electrically connected to the transparent oxide electrode layer (12p) for p-type by covering the transparent oxide electrode layer (12p) for p-type is smaller than or equal to an area of the transparent oxide electrode layer (12p) for p-type, and does not overlap the region A.

## Patentansprüche

1. Solarzellenmodul (20), umfassend:
mindestens eines oder mehrere Solarzellen-Strings (21), die mindestens zwei Solarzellen (10) vom Typ mit beidseitigen Elektroden, die elektrisch miteinander verbunden sind, umfassen,
worin die zumindest zwei Solarzellen (10) vom Typ mit beidseitigen Elektroden jeweils umfassen:
ein Halbleitersubstrat (15);
eine p-Typ-Halbleiterschicht (17p) und eine transparente Oxid-Elektrodenschicht (12p) für p-Typ, die der p-Typ-Halbleiterschicht (17p) entspricht, auf einer Oberflächenseite der Hauptoberflächen (15S) des Halbleitersubstrats (15); und
eine n-Typ-Halbleiterschicht (17n) und eine transparente Oxid-Elektrodenschicht (12n) für n-Typ, die der n-Typ-Halbleiterschicht (17n) entspricht, auf der anderen oberen Flächenseite der Hauptoberflächen (15S) des Halbleitersubstrats (15),
worin, wenn in dem Halbleitersubstrat (15) eine der gegenüberliegenden Seiten als eine Endseite (E1S) definiert ist und die andere als die andere Endseite (E2S) definiert ist,
auf der einen Oberflächenseite auf der einen Endseite (E1S) ein Bereich der p-Typ-Halbleiterschicht (17p), der nicht mit der transparenten Oxid-Elektrodenschicht (12p) für p-Typ bedeckt ist, als "Bereich A" definiert ist,
auf der einen Oberflächenseite auf der anderen Endseite (E2S) ein Bereich der p-Typ-Halbleiterschicht (17p), der nicht mit der transparenten Oxid-Elektrodenschicht (12p) für p-Typ bedeckt ist, als ein "Bereich B" definiert ist, und
worin eine Fläche des Bereichs A größer ist als eine Fläche des Bereichs B;
wobei das Solarzellenmodul **dadurch gekennzeichnet ist, dass** ein Teil der ersten Solarzelle (10) vom Typ mit beidseitigen Elektroden auf der einen Oberflächenseite (15SU) auf der einen Endseite (E1S) mit einem Teil einer zweiten Solarzelle vom Typ mit beidseitigen Elektroden (10) auf der anderen Oberflächenseite (15SB) an der anderen Endseite (E2S) überlappt, ein leitfähiges Adhäsivmittel (22) zwischen den Teilen vorgesehen ist und beide der Solarzellen (10) vom Typ mit beidseitigen Elektroden elektrisch verbindet, und worin ferner
entweder der Bereich A durch die zweite Solarzelle (10) vom Typ mit beidseitigen Elektroden abgeschirmt ist, oder
wenn auf der anderen Oberflächenseite (15S) an der einen Endseite (E1S), in dem Bereich, der nicht mit der transparenten Oxid-Elektrodenschicht (12n) für n-Typ bedeckt ist, der Bereich, der dem Bereich A gegenüberliegt, mit dem Halbleitersubstrat (15) als Grenze, als "Bereich C" definiert ist, der Bereich C durch die zweite Solarzelle (10) vom Typ mit beidseitigen Elektroden abgeschirmt ist.

2. Solarzellenmodul gemäß Anspruch 1, worin in dem zumindest zwei Solarzellen (10) vom Typ mit beidseitigen Elektroden die Länge des Bereichs B entlang der Richtung, die die eine Endseite (E1S) mit der anderen Endseite (E2S) verbindet, weniger als die zweifache Dicke des Halbleitersubstrats (15) beträgt.

3. Solarzellenmodul gemäß Anspruch 1 oder 2, worin in den zumindest zwei Solarzellen (10) vom Typ mit beidseitigen Elektroden, wenn auf der anderen Oberflächenseite (15B) an der anderen Endseite (E2S), in einem Bereich der n-Typ-Halbleiterschicht (17n), der nicht mit der transparenten Oxid-Elektrodenschicht (12n) für n-Typ bedeckt ist, ein Bereich, der dem Bereich B mit dem Halbleitersubstrat (15) als Grenze gegenüber liegt, als "Bereich D" definiert ist,
die Fläche des Bereichs D kleiner ist als oder gleich ist zur Fläche des Bereichs B.

4. Solarzellenmodul gemäß irgendeinem der Ansprüche 1 bis 3, worin in zumindest den zwei Solarzellen (10) vom Typ mit beidseitigen Elektroden, wenn auf der anderen Oberflächenseite (15B) an der einen Endseite (E1S), in einem Bereich der n-Typ-Halbleiterschicht (17n), der nicht mit der transparenten Oxid-Elektrodenschicht (12n) für n-Typ bedeckt ist, ein Bereich, der dem Bereich A mit dem Halbleitersubstrat (15) als Grenze gegenüber liegt, als ein "Bereich C" definiert ist,
die Fläche des Bereichs C größer ist als die Fläche des Bereichs B.

5. Solarzellenmodul gemäß irgendeinem der Ansprüche 1 bis 4, worin in den zumindest zwei Solarzellen (10) vom Typ mit beidseitigen Elektroden, in einem Fall, worin die eine Oberflächenseite (15S) eine lichtempfangende Seite ist, und die andere Oberflächenseite (15B) eine Rückseite ist,
zumindest ein Teil des Bereichs A mit zumindest einem Teil einer Metall-Elektrodenschicht (13p) für p-Typ bedeckt ist, die elektrisch mit der transparenten Oxid-Elektrodenschicht (12p) für p-Typ verbunden ist.

6. Solarzellenmodul gemäß Anspruch 5, worin in den zumindest zwei Solarzellen (10) vom Typ mit beidseitiger Elektrode, wenn auf der anderen Oberflächenseite (15S) auf der einen Endseite (E1S), in einem Bereich, der nicht mit der transparenten Oxid-Elektrodenschicht (12n) für n-Typ bedeckt ist, ein Bereich, der dem Bereich A mit dem Halbleitersubstrat (15) als Grenze gegenüber liegt, als "Bereich C" definiert ist,
die Fläche einer Metall-Elektrodenschicht (13n) für n-Typ, die durch Bedecken der transparenten Oxid-Elektrodenschicht (12n) für n-Typ elektrisch mit der transparenten Oxid-Elektrodenschicht (12n) für n-Typ verbunden ist, kleiner ist zu oder gleich ist zur Fläche der transparenten Oxid-Elektrodenschicht (12n) für n-Typ und nicht mit dem Bereich C überlappt.

7. Solarzellenmodul gemäß irgendeinem der Ansprüche 1 bis 4, worin in den zumindest zwei Solarzellen (10) vom Typ mit beidseitigen Elektroden, wenn die andere Oberflächenseite (15S) eine lichtempfangende Seite (15SU) ist und die andere Oberflächenseite (15SB) eine Rückseite ist,
wenn auf der anderen Oberflächenseite (15S) an der einen Endseite (E1S), in einem Bereich, der nicht mit der transparenten Oxid-Elektrodenschicht (12n) für n-Typ bedeckt ist, ein Bereich, der dem Bereich A mit dem Halbleitersubstrat (15) als Grenze gegenüber liegt, als "Bereich C" definiert ist,
zumindest ein Teil des Bereichs C mit einem Teil einer Metall-Elektrodenschicht (13n) für n-Typ bedeckt ist, die elektrisch mit der transparenten Oxid-Elektrodenschicht (12n) für n-Typ verbunden ist.

8. Solarzellenmodul gemäß Anspruch 7, worin in zumindest den zwei Solarzellen (10) vom Typ mit beidseitiger Elektrode eine Fläche einer Metall-Elektrodenschicht (13p) für p-Typ, die mit der transparenten Oxid-Elektrodenschicht (12p) für p-Typ elektrisch verbunden ist, indem sie die transparente Oxid-Elektrodenschicht (12p) für p-Typ bedeckt, kleiner ist als oder gleich ist zur Fläche der transparenten Oxid-Elektrodenschicht (12p) für p-Typ und nicht mit dem Bereich A überlappt.

## Revendications

1. Module de cellule solaire (20), comprenant :
au moins une ou plusieurs chaînes de cellules solaires (21) qui incluent au moins deux cellules solaires de type à électrode à double face (10) qui sont connectées électriquement,
dans lequel les au moins deux cellules solaires de type à électrode à double face (10) comprennent chacune :
un substrat semi-conducteur (15) ;
une couche semi-conductrice de type p (17p) et une couche d'électrode d'oxyde transparent pour type p (12p) correspondant à la couche semi-conductrice de type p (17p) sur un côté surface des surfaces principales (15S) du substrat semi-conducteur (15) ; et
une couche semi-conductrice de type n (17n) et une couche d'électrode d'oxyde transparent pour type n (12n) correspondant à la couche semi-conductrice de type n (17n) sur l'autre côté surface des surfaces principales (15S) du substrat semi-conducteur (15),
dans lequel, lorsque dans le substrat semi-conducteur (15), l'un des côtés en vis-à-vis est défini comme étant l'une des extrémités (E1S), et l'autre est défini comme étant l'autre extrémité (E2S),
sur le côté surface à l'une des extrémités (E1S), une région de la couche semi-conductrice de type p (17p) qui n'est pas couverte par la couche d'électrode d'oxyde transparent (12p) pour type p est définie comme étant une « région A »,
sur le côté surface à l'autre extrémité (E2S), une région de la couche semi-conductrice de type p (17p) qui n'est pas couverte par la couche d'électrode d'oxyde transparent pour type p (12p) est définie comme étant une « région B », et
dans lequel une aire de la région A est plus grande qu'une aire de la région B ;
le module de cellule solaire étant **caractérisé en ce que**, une partie d'une première cellule solaire de type à électrode à double face (10) sur le côté surface (15SU) à l'une des extrémités (E1S) chevauche une partie d'une seconde cellule solaire de type à électrode à double face (10) sur l'autre côté surface (15SB) à l'autre extrémité (E2S), un adhésif électriquement conducteur (22) est interposé entre les parties et connecte électriquement les deux cellules solaires de type à électrode à double face (10), et en outre
dans lequel soit
la région A est masquée par la seconde cellule solaire de type à électrode à double face (10), ou
lorsque sur l'autre côté surface (15S) à l'une des extrémités (E1S), dans la région qui n'est pas couverte par la couche d'électrode d'oxyde transparent (12n) pour type n, la région faisant face à la région A avec le substrat semi-conducteur (15) comme limite est définie comme étant une « région C », la région C est masquée par la seconde cellule solaire de type à électrode à double face (10).

2. Module de cellule solaire selon la revendication 1, dans lequel, dans les au moins deux cellules solaires de type à électrode à double face (10), une longueur de la région B le long d'une direction reliant l'une des extrémités (E1S) à l'autre extrémité (E2S) est inférieure à 2 fois une épaisseur du substrat semi-conducteur (15).

3. Module de cellule solaire selon la revendication 1 ou la revendication 2, dans lequel, dans les au moins deux cellules solaires de type à électrode à double face (10), lorsque sur l'autre côté surface (15B) à l'autre extrémité (E2S), dans une région de la couche semi-conductrice de type n (17n) qui n'est pas couverte par la couche d'électrode d'oxyde transparent (12n) pour type n, une région faisant face à la région B avec le substrat semi-conducteur (15) comme limite est définie comme étant une « région D »,
une aire de la région D est inférieure ou égale à l'aire de la région B.

4. Module de cellule solaire selon l'une quelconque des revendications 1 à 3, dans lequel, dans les au moins deux cellules solaires de type à électrode à double face (10), lorsque sur l'autre côté surface (15B) à l'une des extrémités (E1S), dans une région de la couche semi-conductrice de type n (17n) qui n'est pas couverte par la couche d'électrode d'oxyde transparent (12n) pour type n, une région faisant face à la région A avec le substrat semi-conducteur (15) comme limite est définie comme étant une « région C »,
une aire de la région C est plus grande que l'aire de la région B.

5. Module de cellule solaire selon l'une quelconque des revendications 1 à 4, dans lequel, dans les au moins deux cellules solaires de type à électrode à double face (10), dans un cas où l'un des côtés surface (15S) est un côté surface de réception de lumière, et l'autre côté surface (15B) est une face arrière,
au moins une partie de la région A est couverte par une partie d'une couche d'électrode métallique pour type p (13p) qui est connectée électriquement à la couche d'électrode d'oxyde transparent pour type p (12p).

6. Module de cellule solaire selon la revendication 5, dans lequel, dans les au moins deux cellules solaires de type à électrode à double face (10), lorsque sur l'autre côté surface (15S) à l'une des extrémités (E1S), dans une région qui n'est pas couverte par la couche d'électrode d'oxyde transparent (12n) pour type n, une région faisant face à la région A avec le substrat semi-conducteur (15) comme limite est définie comme étant une « région C »,
une aire d'une couche d'électrode métallique (13n) pour type n qui est connectée électriquement à la couche d'électrode d'oxyde transparent (12n) pour type n en couvrant la couche d'électrode d'oxyde transparent (12n) pour type n est inférieure ou égale à une aire de la couche d'électrode d'oxyde transparent (12n) pour type n, et ne chevauche pas la région C.

7. Module de cellule solaire selon l'une quelconque des revendications 1 à 4, dans lequel, dans les au moins deux cellules solaires de type à électrode à double face (10), dans un cas où l'autre côté surface (15S) est un côté surface de réception de lumière (15SU), et le premier côté surface (15SB) est une face arrière,
lorsque sur l'autre côté surface (15S) à l'une des extrémités (E1S), dans une région qui n'est pas couverte par la couche d'électrode d'oxyde transparent (12n) pour type n, une région faisant face à la région A avec le substrat semi-conducteur (15) comme limite est définie comme étant une « région C »,
au moins une partie de la région C est couverte par une partie d'une couche d'électrode métallique (13n) pour type n qui est connectée électriquement à la couche d'électrode d'oxyde transparent (12n) pour type n.

8. Module de cellule solaire selon la revendication 7, dans lequel, dans les au moins deux cellules solaires de type à électrode à double face (10), une aire d'une couche d'électrode métallique (13p) pour type p qui est connectée électriquement à la couche d'électrode d'oxyde transparent (12p) pour type p en couvrant la couche d'électrode d'oxyde transparent (12p) pour type p est inférieure ou égale à une aire de la couche d'électrode d'oxyde transparent (12p) pour type p, et ne chevauche pas la région A.
